# EUROPEAN PATENT SPECIFICATION

(11) **EP 2 017 818 B1**
(45) Date of publication and mention of the grant of the patent: **05.04.2017**
(21) Application number: 08012743.4
(22) Date of filing: 15.07.2008
(51) Int. Cl.: G11C 19/18, G09G 3/36

(54) **Display device and method for driving the same**
Anzeigevorrichtung und Ansteuerverfahren dafür
Dispositif d'affichage et son procédé de commande

(30) Priority: 20.07.2007 KR 20070073000
(43) Date of publication of application: 21.01.2009
(73) Proprietor: Samsung Display Co., Ltd., Gyeonggi-do (KR)
(72) Inventor: Lee, Chang-Soo, Gyeonggi-do (KR); Moon, Seung-Hwan, Gyeonggi-do (KR); Lee, Yong-Soon, Cheonan-si Chungcheongnam-do (KR)
(74) Representative: Dr. Weitzel & Partner

(56) References cited:
- EP-A2- 1 515 344
- US-A1- 2005 156 860
- US-A1- 2005 212 746

## Description

### BACKGROUND OF THE INVENTION

### 1. Field of the Invention

The present disclosure relates to a display device and a method for driving the same, and more particularly, to a display device capable of preventing a driving failure, and a method for driving the same.

### 2. Description of the Related Art

A conventional display device includes a display panel, a gate driver, and a data driver. The gate driver sequentially applies gate turn-on signals to a plurality of gate lines disposed within the display panel, and the data driver applies gray-scale signals to a plurality of data lines disposed within the display panel, so that the display panel displays an image. The gate driver is manufactured in an integrated circuit ("IC") chip configuration. Accordingly, the IC-chip-type gate driver is mounted at a periphery of the display panel and is connected to the gate lines of the display panel.

However, a connection failure occurs between the gate driver and the gate lines and a manufacturing cost of the display device increases because the gate driver is provided in a separate IC chip configuration.

To solve these problems, the display panel and the gate driver are simultaneously manufactured. That is, when the display panel is manufactured, the gate driver is simultaneously manufactured at an edge of the display panel. Since the display panel and the gate driver are manufactured by the same process, a manufacturing cost of the gate driver can be reduced and a connection failure between the gate driver and the gate lines can be solved.

Since the gate driver and the display panel are simultaneously manufactured, circuit elements of the gate driver are formed of amorphous silicon. Amorphous silicon has a drawback since electron mobility greatly changes depending on temperature. Hence, when the ambient temperature is lowered, response speeds of circuit elements made of amorphous silicon are rapidly reduced.

Therefore, when the ambient temperature is lowered, the gate driver outputs a gate turn-on signal of an abnormal voltage level. Since the drivability of the circuit elements of the gate driver is reduced, the gate driver outputs the gate turn-on signal having a voltage level lower than a target voltage level. Further, when the driving of the gate driver is controlled using the gate turn-on signal applied through a gate line of a previous stage, a gate turn-on signal having an abnormal voltage level may affect the next stage, so that a gate turn-on signal of the next gate line also includes an abnormal voltage level. Due to the gate turn-on signals of the abnormal voltage level, the display panel cannot correctly display an image.

Document US 2005/0156860 A1 discloses a shift register used in a display device that is configured to decrease a distortion of the output signal.

### BRIEF SUMMARY OF THE INVENTION

The present invention has made an effort to solve the above stated problems and aspects of the present invention provide a display device capable of preventing the lowering of the voltage level of a gate turn-on signal applied to a first gate line at a low temperature by changing the voltage levels of control signals applied to a gate driver, thereby displaying a correct image even at a low temperature, and a method for driving the same.

According to an exemplary embodiment, the present invention provides a display device which includes a display panel including a plurality of gate lines connected to a plurality of pixels, a gate clock generator which generates gate clock signals in which a width of a logic high period of a first gate clock signal is smaller than that of other gate clock signals during one frame period, and a gate driver which sequentially applies gate turn-on signals to the gate lines, according to the gate clock signal and a gate clock bar signal having a phase opposite to the other gate clock signals.

According to an exemplary embodiment, the display device further includes a signal converter which outputs a second output enable signal according to a first output enable signal and a first vertical sync start signal, wherein the gate clock generator generates a second vertical sync start signal, the gate clock signal, and the gate clock bar signal according to the second output enable signal, the first vertical sync start signal, and a driving clock signal.

According to an exemplary embodiment, the second output enable signal maintains a logic low level during a logic high period of the first vertical sync start signal. Further, the gate driver is driven in response to the second vertical sync start signal.

According to an exemplary embodiment, the display device further includes a signal controller which outputs the first output enable signal, the first vertical sync start signal and the driving clock signal.

According to an exemplary embodiment, the gate clock signal is a logic high level when the second output enable signal or the driving clock signal is a logic low level, the gate clock signal is a logic low level when the second output enable signal and the driving clock signal are logic low levels.

According to an exemplary embodiment, the signal converter includes an input/output node which receives the first output enable signal and output the second output enable signal, and a switching unit which electrically connects the input/output node to the ground in response to the first vertical sync start signal.

According to an exemplary embodiment, the signal converter includes a first logic gate which performs a NAND operation on the first vertical sync start signal and the first output enable signal, and a second logic gate which performs an AND operation on an output of the first logic gate and the first output enable signal.

According to an exemplary embodiment, the width of the logic high period of the other gate clock signals is approximately 1H and the width of the logic high period of the first gate clock signal is approximately 30-60% of 1H.

According to an exemplary embodiment, the gate driver includes a plurality of stages integrated into the display panel and respectively, connected to the plurality of gate lines. A first stage connected to a first gate line outputs the gate turn-on signal according to the second vertical sync start signal and the first gate clock signal and the other stages output the gate turn-on signals according to outputs of previous stages, the other gate clock signals, and the gate clock bar signals.

According to an exemplary embodiment, the gate clock generator inverts the logic levels of the other gate clock signals and the gate clock bar signals when a logic OR operation of the second output enable signal and the driving clock signal is zero.

Each of the pixels includes a thin film transistor connected to the gate line, and a liquid crystal capacitor connected to the thin film transistor.

In another exemplary embodiment, the present invention provides a display device which includes a display panel including a plurality of gate lines connected to a plurality of pixels, a gate clock generator which generates a second output enable signal by converting a first output enable signal to a logic low level during a logic high period of a first vertical sync start signal, and generates gate clock signals in which a width of a logic high period of a first gate clock signal is smaller than that of other gate clock signals during one frame period according to the second output enable signal and a driving clock signal, and a gate driver which sequentially applies gate turn-on signals to the gate lines according to a second vertical sync start signal converted from the first vertical sync start signal, the gate clock signal, and a gate clock bar signal having a phase opposite to the other gate clock signals after the first gate clock signal.

Further, according to another exemplary embodiment, the present invention provides a method for driving a display device which includes generating an output enable signal having a logic low level during a logic high period of a first vertical sync start signal which indicates a start of one frame, generating gate clock signals, a gate clock bar signal, and a second vertical sync start signal using the output enable signal, the first vertical sync start signal, the driving clock signal, a gate turn-on signal, and a gate turn-off signal in which a width of a logic high period of the gate clock signal during the period of the first vertical sync start signal is smaller than that of clock signals in the other periods, and the gate clock bar signal has a phase opposite to the other gate clock signals after the first gate clock signal, and sequentially applying gate turn-on signals to a plurality of gate lines according to the second vertical sync start signal, the gate clock signal, and the gate clock bar signal.

According to an exemplary embodiment, the width of the logic high period of the other gate clock signals of the other periods is approximately 1H, and the width of the logic high period of the gate clock signal during the period of the first vertical sync start signal is approximately 30-60% of 1H.

According to an exemplary embodiment, the width of the logic high period of the first vertical sync start signal is approximately 1H.

According to an exemplary embodiment, the logic levels of the other gate clock signals and the gate clock bar signals is inverted when a logic OR operation of the output enable signal and the driving clock signal is zero.

### BRIEF DESCRIPTION OF THE DRAWINGS

The above and/or other aspects, features and advantages of the present invention will become more apparent from the following detailed description when taken in conjunction with the accompanying drawings, in which:
FIG. 1 is a block diagram of an exemplary embodiment of a display device according to the present invention;
FIG. 2 is a detailed block diagram of an exemplary embodiment of a portion of the display device according to the present invention;
FIG. 3 is a circuit diagram of an exemplary embodiment of a first stage according to the present invention;
FIG. 4 is a circuit diagram of an exemplary embodiment of a signal converter according to the present invention;
FIG. 5 is a circuit diagram of another exemplary embodiment of a signal converter according to the present invention; and
FIG. 6 is a waveform diagram illustrating exemplary embodiments of an operation of the display device according to the present invention.

### DETAILED DESCRIPTION OF INVENTION

The invention now will be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, exemplary embodiments of the present invention will be described in detail with reference to the accompanying drawings.

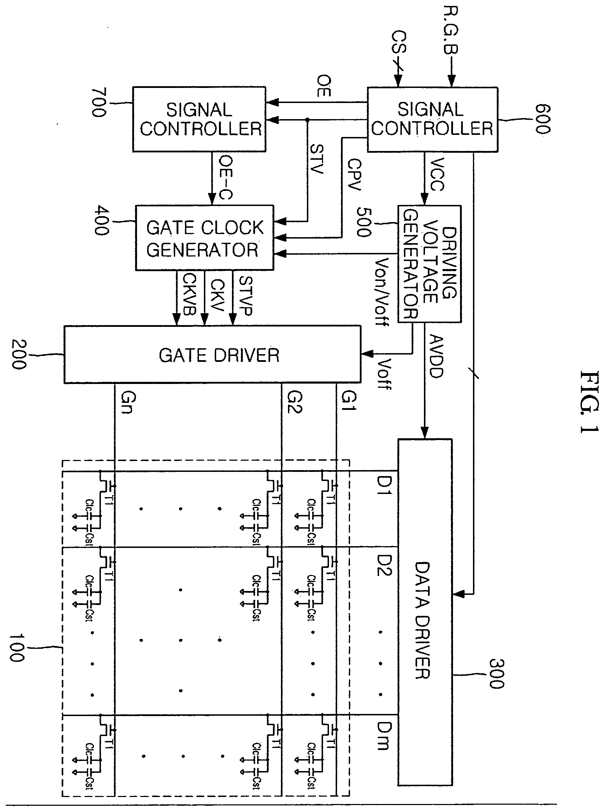

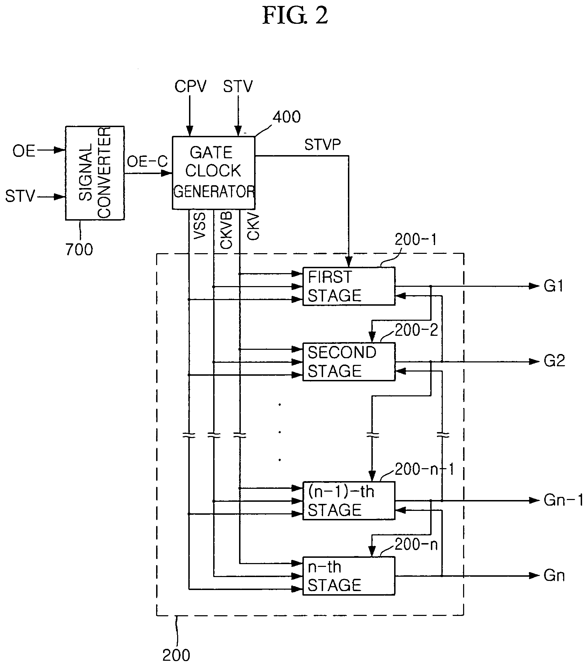

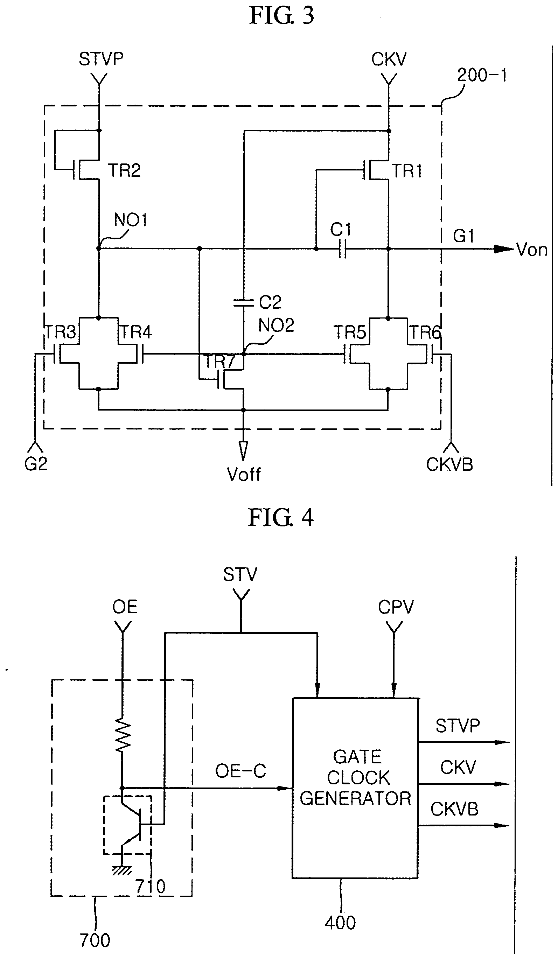

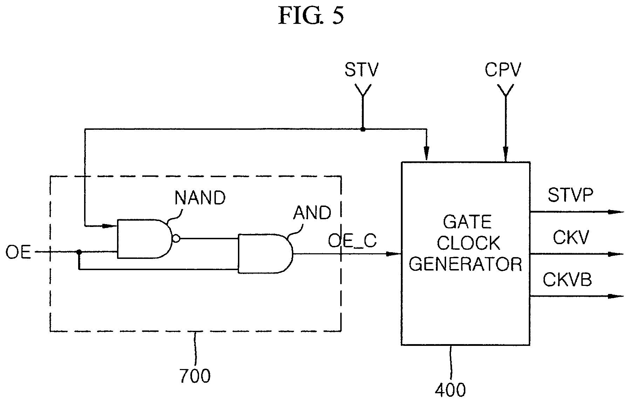

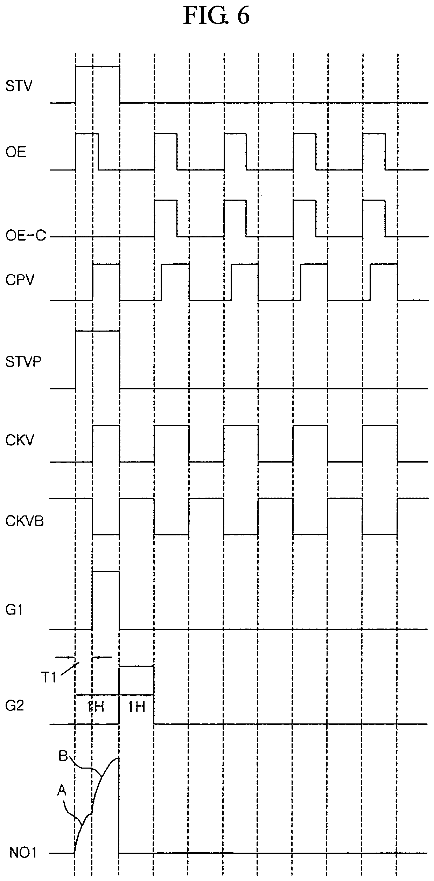

FIG. 1 is a block diagram of an exemplary embodiment of a display device according to the present invention. FIG. 2 is a detailed block diagram of an exemplary embodiment of a portion of the display device according to the present invention. FIG. 3 is a circuit diagram of an exemplary embodiment of a first stage according to the present invention. FIG. 4 is a circuit diagram of an exemplary embodiment of a signal converter according to the present invention. FIG. 5 is a circuit diagram of another exemplary embodiment of a signal converter according to the present invention. FIG. 6 is a waveform diagram illustrating exemplary embodiments of an operation of the display device according to the present invention.

Referring to FIGS. 1 through 4, the display device includes a display panel 100, a gate driver 200, a data driver 300, a gate clock generator 400, a driving voltage generator 500, a signal controller 600, and a signal converter 700.

The display panel 100 includes a plurality of gate lines G1 to Gn which extend in one direction, and a plurality of data lines D1 to Dm which extend in a direction crossing the gate lines G1 to Gn. In addition, the display panel 100 includes a plurality of pixels PX connected to the gate lines G1 to Gn and the data lines D1 to Dm. The pixels PX are arranged in a matrix form within a display region of the display panel 100. Each of the pixels PX includes a thin film transistor ("TFT") T and a pixel capacitor Clc. According to an exemplary embodiment, each of the pixels PX further includes a storage capacitor Cst. The plurality of pixels display red (R), green (G) or blue (B), respectively.

The display panel 100 includes a top substrate (not shown) and a bottom substrate (not shown). The bottom substrate includes TFTs T, gate lines. G1 to Gn, data lines D1 to Dm, pixel electrodes for pixel capacitors Clc and storage capacitors Cst, and storage electrodes for storage capacitors Cst. The top substrate includes a light blocking pattern (e.g., a black matrix), a color filter, and common electrodes for the pixel capacitors Clc. A liquid crystal layer (not shown) is interposed between the top substrate and the bottom substrate.

Gate terminals of the TFTs T are connected to the gate lines G1 to Gn, source terminals are connected to the data line D1 to Dm, drain terminals are connected to the pixel electrodes. The TFTs T operate in response to gate turn-on signals applied to the gate lines G1 to Gn and supply data signals (i.e., gray-scale signals) of the data lines D1 to Dm to the pixel electrodes to change electric fields formed across the pixel capacitors Clc. Due to the change of the electric fields, the arrangement of liquid crystals within the display panel 100 is changed, and thus, the transmittance of light supplied from a backlight is controlled.

The pixel electrodes, according to an exemplary embodiment, include a plurality of cut-away and/or protrusion patterns as a domain regulator which regulates the alignment direction of the liquid crystals. Further, the common electrodes may include a plurality of protrusion and/or cut-away patterns. In the current exemplary embodiment, the liquid crystals are vertically aligned. However, the present invention is not limited hereto, and may vary as necessary.

According to an exemplary embodiment, the control elements such as the gate driver 200, the data driver 300, the gate clock generator 400, the driving voltage generator 500, the signal controller 600, and the signal converter 700 are provided outside the display panel 100. These control elements supply driving control signals to the display panel 100, so that the display panel 100 receives external light and displays an image. The control elements are manufactured as IC chip and are electrically connected to the display panel 100. The respective control elements may be separately manufactured, or some of them may be integrated in a single chip. Some of the control elements may also be manufactured together with the display panel 100. In the current exemplary embodiment, the gate driver 200 is integrated into the bottom substrate of the display panel 100. That is, the gate driver 200 is manufactured together with the TFTs T of the display panel 100. The control elements will be described below in more detail.

The signal controller 600 receives image signals R, G and B and an image control signal CS from an external graphic controller (not shown). The image signals R, G and B include primary pixel data, i.e., red, green, and blue color data. The image control signal CS includes a vertical sync signal ("Vsync"), a horizontal sync signal ("Hsync"), a main clock ("DCLK"), and a data enable signal ("DE"). The signal controller 600 processes the image signals R, G and B in accordance with operation conditions of the display panel 100.

The signal controller 600 generates a plurality of control signals including a gate control signal and a data control signal. More specifically, the signal controller 600 transmits the gate control signal to the signal converter 700 and the gate clock generator 400, and transmits the data control signal to the data driver 300. The gate control signal includes a first output enable signal OE, a first vertical sync start signal STV, and a driving clock signal CPV. The data control signal (not shown) includes a horizontal sync start signal, a load signal, and a data clock signal. The horizontal sync start signal indicates the starting of transmission of the pixel data signal. The load signal instructs the application of a data voltage to a corresponding data line. In addition, according to an exemplary embodiment, the data control signal further includes an inversion signal which inverts the polarity of a gray-scale voltage with respect to a common voltage.

The signal controller 600 is manufactured in an IC chip configuration and is mounted on a printed circuit board ("PCB") (not shown) electrically connected to the display panel 100. Although not shown, the signal controller 600 is electrically connected to the gate driver 200 through a flexible printed circuit board ("FPCB") (not shown) connected to the PCB (not shown).

The driving voltage generator 500 generates a variety of driving voltages necessary for driving the display device using an external voltage VCC received from the signal controller 600. The driving voltage generator 500 generates a reference voltage AVDD, a gate turn-on voltage Von, a gate turn-off voltage Voff, and a common voltage. The driving voltage generator 500 applies the gate turn-on voltage Von and the gate turn-off voltage Voff to the gate clock generator 400 and applies the reference voltage AVDD to the data driver 300 according to the control signals of the signal controller 600. The reference voltage AVDD is used as a standard voltage to generate a gray-scale voltage for driving the liquid crystals.

The data driver 300 generates the gray-scale signals by using the data control signal and the pixel data signal from the signal controller 600 and the reference voltage AVDD from the driving voltage generator 500, and applies the generated gray-scale signals to the respective data lines D1-Dm. That is, the data driver 300 is driven according to the data control signal and converts digital pixel data signals into analog gray-scale signals using the reference voltage AVDD. The data driver 300 supplies the converted gray-scale signals to the plurality of data lines D1 to Dm

The signal converter 700 outputs a second output enable signal OE-C according to the first output enable signal OE and the first vertical sync start signal STV. The signal converter 700 changes the first output enable signal OE to a logic low level during a period in which the first vertical sync start signal STV is applied. That is, the second output enable signal OE-C is maintained at a logic low level during a logic high period of the first vertical sync start signal STV, and includes the same logic level as the first output enable signal OE during the remaining period. The first vertical sync start signal STV indicates the start of one frame and the first vertical sync start signal STV is a single pulse signal having one logic high period during one frame.

The gate clock generator 400 generates a second vertical sync start signal STVP, a gate clock signal CKV, and a gate clock bar signal CKVB according to the second output enable signal OE-C, the first vertical sync start signal STV, the driving clock signal CPV, and the gate turn-on voltage Von and the gate turn-off voltage Voff of the driving voltage generator 500. The gate clock generator 400 supplies the second vertical sync start signal STVP, the gate clock signal CKV, and the gate clock bar signal CKVB to the gate driver 200.

The gate clock signal CKV, the gate clock bar signal CKVB, and the second vertical sync start signal STVP have the voltage level of the gate turn-on voltage Von and the gate turn-off voltage Voff. For example, the second vertical sync start signal STVP is generated by increasing the voltage level of the first vertical sync start signal STV up to the voltage level of the gate turn-on voltage Von. That is, the second vertical sync start signal STVP includes the same waveform as the first vertical sync start signal STV. However, the second vertical sync signal STVP includes the voltage level of the gate turn-on voltage Von during its logic high period.

The gate driver 200 applies the gate turn-on signal Von and the gate turn-off signal Voff to the plurality of gate lines G1 to Gn according to the second vertical sync start signal STVP, the gate clock signal CKV, and the gate clock bar signal CKVB. The gate turn-on signal Von is sequentially supplied to the plurality of gate lines G1 to Gn. The gate turn-on signal Von is a single pulse signal during one frame period. According to an exemplary embodiment, the gate turn-on signal Von may be supplied to the gate lines G1 to Gn during one horizontal clock period (1H). The gate turn-on signal Von may be supplied to the gate lines G1 to Gn during a logic high period of the gate clock signal CKV or the gate clock bar signal CKVB. Therefore, the TFTs T connected to the respective gate lines G1 to Gn are turned on, and images are displayed.

In the current exemplary embodiment, since the signal converter 700 which converts the first output enable signal OE using the first vertical sync start signal STV is located between the signal controller 600 and the gate clock generator 400, it is possible to prevent the voltage level of the gate turn-on signal Von , which is applied to the first gate line G1, from being distorted (i.e., decreased) by a low ambient temperature. This will be described below in more detail.

The gate driver 200 will be described with reference to FIG. 2.

Referring to FIG. 2, the gate driver 200 includes first to n-th stages 200-1 to 200-n connected to the plurality of gate lines G1 to Gn, respectively. The first to n-th stages 200-1 to 200-n supply the gate turn-on signal Von or the gate turn-off signal Voff to the plurality of gate lines G1 to Gn according to the plurality of operation signals. The operation signals include the gate clock signal CKV, the gate clock bar signal CKVB, and the second vertical sync start signal STVP or output signals of the previous stages 200-1 to 200-n-1.

The first stage 200-1 is driven by the second vertical sync start signal STVP, the gate clock signal CKV, the gate clock bar signal CKVB, and the gate turn-off signal Voff, and applies the first gate turn-on signal Von to the first gate line G1. The second to n-th stages 200-2 to 200-n are driven by the output signals (i.e., the gate turn-on signals Von) of the previous stages 200-1 to 200-n-1, the gate clock signal CKV and the gate clock bar signal CKVB, and apply the gate turn-on signals Von to the second to n-th gate lines G2 to Gn, respectively. The first to (n-1)-th stages 200-1 to 200-n-1 are reset by the output signals (i.e., the gate turn-on signals Von) of their next stages, i.e., the second to n-th stages 200-2 to 200-n. The last stage, i.e., the n-th stage 200-n, may also be reset by an output signal of a dummy stage (not shown) disposed under the n-th stage 200-n. The n-th stage 200-n may also be reset by a separate control signal.

As illustrated in FIG. 3, according to an exemplary embodiment, each of the first to n-th stages 200-1 to 200-n may include seven TFTs. However, the present invention is not limited hereto and may vary, as necessary. For description purposes only, the following description will be focused on the first stage 200-1. The first stage 200-1 includes a first transistor TR1, a second transistor TR2, a third transistor TR3, a fourth transistor TR4, a fifth transistor TR5, a sixth transistor TR6, a seventh transistor TR7, a first capacitor C1 and a second capacitor C2. The first transistor TR1 provides the gate clock signal CKV of a gate clock signal input terminal to a signal output terminal in response to the signal of the first node NO1. The second transistor TR2 provides the second vertical sync start signal STVP to a first node NO1 in response to the second vertical sync start signal STVP. The third transistor TR3 provides the signal of the first node NO1 to the ground voltage VSS in response to an output signal of the second stage 200-2. The fourth transistor TR4 provides the signal of the first node NO1 to the ground voltage VSS in response to a signal of a second node NO2. The fifth transistor TR5 provides a signal from the signal output terminal to the ground voltage VSS in response to the signal of the second node NO2. The sixth transistor TR6 provides a signal of the signal output terminal to the ground voltage VSS in response to the gate clock bar signal CKVB. The seventh transistor TR7 provides the signal of the second node NO2 to the ground voltage VSS in response to the signal of the first node NO1. The first capacitor C1 is connected between the first node NO1 and the signal output terminal. The second capacitor C2 is connected between the second node NO2 and the input terminal of the gate clock signal CKV. According to an exemplary embodiment, the input terminal of the gate clock signal CKV and the input terminal of the gate clock bar signal CKVB may be exchanged with each other. The second to n-th stages 200-2 to 200-n receive the output signals of the previous stages, i.e., the first to (n-1)-th stages 200-1 to 200-n-1, instead of the second vertical sync start signal STVP. A simplified circuit configuration of the stage is illustrated in FIG. 3 and, if necessary, a variety of circuit elements may be further included in the stage. The voltage levels of the second vertical sync start signal STVP, the gate clock signal CKV, and the gate clock bar signal CKVB are similar or equal to the voltage level of the gate turn-on signal Von.

An operation of the first stage 200-1 will be described below with reference to FIGS. 3 and 6.

Referring to FIGS. 3 and 6, the second vertical sync start signal STVP is supplied to the first stage 200-1. The second vertical sync start signal STVP is applied to the first node NO1 through the second transistor TR2. The first transistor TR1 is turned on in response to the second vertical sync start signal STVP applied to the first node NO1. The first capacitor C1 is charged to a voltage corresponding to the voltage level of the second vertical sync start signal STVP as indicated by "A" in FIG. 6. In the current exemplary embodiment, the charging time of the first capacitor C1 in the first stage 200-1 can be sufficiently ensured by the gate clock signal CKV generated using the second output enable signal OE-C outputted from the signal converter 700. As illustrated in FIG. 6, since the gate clock signal CKV is maintained at a logic low level during a period T1 corresponding to approximately 30-60% of one horizontal clock period 1H, the period T1 can be used as the charging time of the first capacitor C1. According to an exemplary embodiment, a period corresponding to approximately 50% of 1 horizontal clock period 1H is used as the charging time of the first capacitor C1.

Then, the gate clock signal CKV of a logic high level is supplied to the first stage 200-1. The gate clock signal CKV is applied to the signal output terminal through the turned-on first transistor TR1. As indicated by "B" of FIG. 6, when the gate clock signal CKV of the logic high level is applied to the signal output terminal, the voltage level of the first node NO1 increases due to the coupling of the first capacitor C1. As the voltage level of the first node NO1 increases, the first transistor TR1 is fully turned on. Therefore, the gate clock signal CKV can be provided to the signal output terminal without voltage drop. The gate clock signal CKV on the signal output terminal is applied as the gate turn-on signal to the first gate line G1.

FIG. 6 is a waveform diagram of the signals used in the display device on the assumption that no delay occurs in the signals. According to an exemplary embodiment, the signals of FIG. 6 may be inclined during the level transition due to the signal delay.

As described above, the voltage of the first node NO1 increases up to the voltage level of the second vertical sync start signal STVP at an early stage and its voltage level increases by the first capacitor C1 when the gate clock signal CKV is inputted. At this point, when the ambient temperature is low, e.g., below 10 °C, the driving ability of the first and second transistors TR1 and TR2 is reduced. Therefore, the gate clock signal CKV is applied before the first capacitor C1 is sufficiently charged, so that the voltage level of the first node NO1 does not sufficiently increase. Because the first transistor TR1 is not fully turned on, the voltage level of the gate turn-on signal is decreased. In the exemplary embodiment, however, the gate clock signal CKV is applied after a predetermined time (T1 in FIG. 6) elapses from the application of the second vertical sync start signal STVP. In this way, the first capacitor C1 can be sufficiently charged. Consequently, the voltage level of the first node NO1 is sufficiently increased and the first transistor TR1 is fully turned on, thereby preventing the decrease of the voltage level of the gate turn-on signal.

As illustrated in FIG. 6, the logic high period of the gate clock signal CKV applied to the first stage 200-1 is reduced so as to provide a sufficient charging time to the first capacitor C1 of the first stage 200-1. This means the variation of the pulse width of the gate turn-on signal applied to the first gate line G1.

The current exemplary embodiment, the second output enable signal OE-C is generated using the first output enable signal OE and the first vertical sync start signal STV, and it is applied to the gate clock generator 400 so as to generate gate clock signal CKV. That is, the logic high period of the gate clock signal CKV applied to the firs stage 200-1 is reduced because the signal converter 700 provides the second output enable signal OE-C to the gate clock generator 400. The gate clock generator 400 generates the gate clock signal CKV and the gate clock bar signal CKVB by using the logic 'OR' operation of the second output enable signal OE-C and the driving clock signal CPV. The logic 'OR' operation output a logic high level when the second output enable signal OE-C or the driving clock signal CPV is a logic high level. And the logic 'OR' operation output a logic low level when the second output enable signal OE-C and the driving clock signal CPV are logic low levels. The voltage levels of the gate clock signal CKV and the gate clock bar signal CKVB are the gate turn-on voltage Von and the gate turn-off voltage Voff. The gate clock generator 400 generates the second vertical sync start signal STVP by using the first vertical sync start signal STV, the gate turn-on voltage Von, and the gate turn-off voltage Voff.As illustrated in FIG. 6, during the first 1H period of one frame, the gate clock generator 400 generates the gate clock signal CKV of a logic high level when the second output enable signal OE-C or the driving clock signal CPV is a logic high level. After the first 1H period, the gate clock generator 400 inverts the logic levels of the gate clock signal CKV and the gate clock bar signal CKVB when the logic OR operation of the second output enable signal OE-C and the driving clock signal CPV is zero. That is, when the second output enable signal OE-C of a logic low level or the driving clock signal CPV of a logic low level switches to a logic high level, the gate clock generator 400 inverts the logic level of the gate clock signal CKV. At this point, the gate clock signal CKV of the logic high level becomes the gate turn-on signal Von, and the voltage of the logic low level becomes the gate turn-off signal Voff. Further, as indicated by "T1" in FIG. 6, the gate clock signal CKV is not applied as the output signal when both the second output enable signal OE-C and the driving clock signal CPV are at the logic low level during the logic high period of the second vertical sync start signal STVP. During this logic high period of the second vertical sync start signal STVP, the first capacitors C1 of the stages 200-1 to 200-n are charged up by the external signal.

The generation of the first gate clock signal CKV applied to the first stage 200-1 will be described below. Referring to FIG. 6, during a period in which the second vertical sync start signal STVP is applied, while the second output enable signal OE-C is maintained at the logic low level, the driving clock signal CPV changes from the logic low level to the logic high level. Therefore, the first gate clock signal CKV has a logic low level when both the second output enable signal OE-C and the driving clock signal CPV are in the logic low level, but has a logic high level when the driving clock signal CPV changes to the logic high level. Hence, the first capacitor C1 of the first stage 200-1 can be sufficiently charged to the voltage level of the second vertical sync start signal STVP because both the second output enable signal OE-C and the driving clock signal CPV maintain the logic low level for a long period. Then, the second output enable signal OE-C changes from the logic low level to the logic high level and again changes to the logic low level. The driving clock signal CPV changes from the logic low level to the logic high level. At this point, the second output enable signal OE-C maintains the logic low level for a short period and then changes to the logic high level. Therefore, the period in which both the second output enable signal OE-C and the driving clock signal CPV maintain the logic low level is shortened. Instead, the period in which the second output enable signal OE-C and/or the driving clock signal CPV maintain(s) the logic high level is lengthened. Thus, the turn-on time of the TFT connected to one gate line becomes long. In this case, the gate clock bar signal CKVB has a phase opposite to that of the remaining gate clock signals CKV except the first gate clock signal CKV within one frame. That is, the gate clock bar signal CKVB maintains the logic low level during the first horizontal clock period 1H, and it has a phase opposite to that of the gate clock signal CKV during the following horizontal clock periods.

As described above, the second output enable signal OE-C supplied to the gate clock generator 400 so as to generate the gate clock signal CKV is generated in the signal converter 700 using the first output enable signal OE and the first vertical sync start signal STV. That is, the first stage is operated by the first vertical sync start signal STV to supply the gate turn-on signal to the first gate line G1. Therefore, during the logic high period of the first vertical sync start signal STV, the second output enable signal OE-C is generated by forcibly changing the first output enable signal OE to the logic low level. In this way, the period in which both the second output enable signal OE-C and the driving clock signal CPV are at the logic low level can be sufficiently long. Consequently, the time when the first capacitor C1 of the first stage is charged to the second vertical sync time signal STVP is lengthened.

As illustrated in FIG. 4, the signal converter 700 includes an input/output node I/O and a switching unit 710. The signal converter 700 converts the first output enable signal OE to output the second output enable signal OE-C. The switching unit 710 electrically connects the input/output node I/O to the ground in response to the first vertical sync start signal STV. The switching unit 710 may be implemented with a transistor. That is, the signal converter 700 outputs the first output enable signal OE as the second output enable signal OE-C when the first vertical sync start signal STV is logic low level (i.e. ground), and outputs the logic low level signal (i.e., the ground voltage signal VSS) as the second output enable signal OE-C when the first vertical sync signal STV is logic high level. Therefore, during the period in which the first vertical sync start signal STV is applied, the second output enable signal OE-C includes the logic low level, regardless of the logic level of the first output enable signal OE. The signal converter 700 having the switching unit 710 is connected to an input pin of the gate clock generator 400 to convert the first output enable signal OE of the signal controller 600, so that the second output enable signal OE-C can be provided to the gate clock generator 400. During the period in which the first vertical sync start signal STV is applied, the width of the logic high period of the gate clock signal CKV is changed using the second output enable signal OE-C. Thus, the voltage drop of the gate turn-on signal Von at a low temperature is prevented, thereby the low-temperature driving ability can be improved.

The signal converter 700 is not limited to the above-mentioned configuration, but can be implemented with a variety of circuit configurations. As illustrated in FIG. 5, the signal converter 700 includes a first logic gate to perform a NAND operation on the first vertical sync start signal STV and the first output enable signal OE, and a second logic gate to perform an AND operation on an output of the first logic gate and the first output enable signal OE. The first logic gate is implemented with a NAND gate "NAND", and the second logic gate is implemented with an AND gate "AND". That is, the NAND gate "NAND" outputs the logic low signal when both the first output enable signal OE and the first vertical sync start signal STV have the logic high level. When the output of the NAND gate "NAND" is the logic low level, the AND gate "AND" outputs the second output enable signal OE-C of the logic low level, regardless of the logic level of the first output enable signal OE. Using the signal converter 700, the logic high period of the first output enable signal OE can be eliminated within the logic high period of the first vertical sync start signal STV.

An operation of the display device will be described below in detail with reference to FIG. 6.

The signal controller 600 generates the gate control signals and the data control signals according to the external control signal inputted from the external controller. The gate control signals include the first output enable signal OE, the driving control signal CPV, and the first vertical sync start signal STV. The data control signals include the pixel data signal. The signal controller 600 outputs the first output enable signal OE and the driving clock signal CPV. The signal controller 600 outputs the first vertical sync start signal STV at each start of one frame.

The signal converter 700 forcibly changes the first output enable signal OE to the logic low level during the logic high period of the first vertical sync start signal STV, and outputs the second output enable signal OE-C to the gate clock generator 400. At this point, the second output enable signal OE-C maintains the logic low level during the logic high period of the first vertical sync start signal STV and includes the same logic level as the first output enable signal OE during the remaining periods.

The gate clock generator 400 generates the gate clock signal CKV and the gate clock bar signal CKVB according to the second output enable signal OE-C and the driving clock signal CPV. The gate clock generator 400 generates the second vertical sync start signal STVP according to the first vertical sync start signal STV. Amplitudes of the gate clock signal CKV, the gate clock bar signal CKVB, and the second vertical sync start signal STVP have the same voltage level as the gate turn-on voltage Von. The width of the logic high periods of the gate clock signal CKV and the gate clock bar signal CKVB is equal to the sum of the logic high periods of the second output enable signal OE-C and the driving clock signal CPV. The width of the logic high period of the second vertical sync start signal STVP is equal to that of the first vertical sync start signal STV. Therefore, the second output enable signal OE-C includes the logic low level during the period in which the first vertical sync start signal STV is applied. During the period in which the first vertical sync start signal STV is applied, the gate clock generator 400 generates the gate clock signal CKV of the logic high level only when the driving clock signal CPV is at the logic high level. That is, during the period in which the first vertical sync start signal STV is applied, the gate clock signal CKV maintains the logic high level during the latter half of the first horizontal clock period 1H, not during the entire horizontal clock period 1H.

The gate driver 200 supplies the gate turn-on signals Von to the gate lines G1 to Gn according to the second vertical sync start signal STVP, the gate clock signal CKV, and the gate clock bar signal CKVB. The gate driver 200 includes the plurality of stages 200-1 to 200-n connected to the gate lines G1 to Gn to apply the gate turn-on signals Von to the corresponding gate lines G1 to Gn using the inputted signals. The width of the logic high period of the gate clock signal CKV is reduced during the period in which the first vertical sync start signal STV, that is, the second vertical sync start signal STVP is applied. The first stage 200-1 connected to the first gate line G1 is driven by the second vertical sync start signal STVP. The gate clock signal CKV is applied to the first stage 200-1 after a predetermined time (e.g., about H/2) elapses from the application of the second vertical sync start signal STVP. Therefore, the gate turn-on signal Von having the period width smaller than the one horizontal clock period 1H is applied to the first gate line G1. However, the first capacitor C1 of the first stage 200-1 can be sufficiently charged to the voltage level of the second vertical sync start signal STVP because the gate clock signal CKV is applied after a predetermined time elapses from the application of the second vertical sync start signal STVP. As described above, the gate turn-on signal Von having the normal voltage level is applied to the first gate line G1 without voltage drop. In the current exemplary embodiment, the width of the logic high period of the gate clock signal CKV applied to the first gate line is adjusted using the signal converter 700 which converts the logic level of the first output enable signal OE according to the first vertical sync start signal STV. Therefore, when the gate driver 200 is integrated into the display panel 100 in the stage form, it is possible to prevent the voltage level of the gate turn-on signal Von applied to the first gate line G1 from being distorted by the reduced drivability of the stage according to the ambient temperature.

As described above, the lowering of the voltage level of a gate turn-on signal Von applied to a first gate line at a low temperature can be prevented by changing the logic level of the output enable signal according to the vertical sync start signal.

In addition, the logic level of the output enable signal is changed using switches or logic circuits, so that increase of the manufacturing cost can be minimized and the driving ability at a low temperature can be improved.

It has been described in the above exemplary embodiments of the present invention that the signal converter 700 is provided in a separate chip or circuit configuration so that it is separated from the signal controller 600 and the gate clock generator 400. However, the present invention is not limited to this configuration. For example, a separate module serving as the signal converter 700 can be provided in the signal controller 600 or the gate clock generator 400.

While the present invention has been shown and described with reference to some exemplary embodiments thereof, it should be understood by those of ordinary skill in the art that various changes in form and details may be made therein without departing from the scope of the present invention as defined by the appending claims.

## Claims

1. A display device comprising:
a display panel (100) comprising a plurality of gate lines (G1 to Gn) connected to a plurality of pixels (PX);
a gate clock generator (400) which generates gate clock signals (CKV) in which a width of a logic high period of a first gate clock signal (CKV) is smaller than that of other gate clock signals (CKV) during one frame period;
a gate driver (200) which sequentially applies gate turn-on signals (Von) to the gate lines (G1 to Gn) according to the gate clock signal (CKV) and a gate clock bar signal (CKVB) having a phase opposite to the other gate clock signals (CKV), wherein the gate driver (200) comprises a plurality of stages (200-1 to 200-n) integrated into the display panel (100) and respectively connected to the plurality of gate lines (G1 to Gn), a first stage (200-1) connected to a first gate line (G1) outputs the gate turn-on signal according to the second vertical sync start signal (STVP) and the first gate clock signal (CKV), and the other stages (200-2 to 200-n) output the gate turn-on signals (Von) according to outputs of previous stages (200-1 to 200-(n-1)), the other gate clock signals (CKV), and the gate clock bar signals (CKVB); and
a signal converter (700) which outputs a second output enable signal (OE-C) according to a first output enable signal (OE) and a first vertical sync start signal (STV), wherein the gate clock generator (400) generates a second vertical sync start signal (STVP), the gate clock signal (CKV), and the gate clock bar signal (CKVB) according to the second output enable signal (OE-C), the first vertical sync start signal (STV), and a driving clock signal (CPV),
wherein at least the first stage (200-1) includes:
a first transistor (TR1) connected between an input terminal for receiving the gate clock signal (CKV) and a first node (NO1), wherein the first transistor (TR1) is adapted to provide the gate clock signal (CKV) to a signal output terminal in response to the signal of the first node (NO1),
a second transistor (TR2) connected between an input terminal for receiving the second vertical sync start signal (STVP) and the signal output terminal, wherein the second transistor (TR2) is adapted to provide the second vertical sync start signal (STVP) to the first node (NO1) in response to the second vertical sync start signal (STVP),
a first capacitor (C1) connected between the first node (NO1) and the signal output terminal, and
wherein the first capacitor (C1) is charged during a charging time (T1) to a voltage (A) corresponding to the voltage level of the second vertical sync start signal (STVP), wherein the gate clock signal (CKV) is applied after the charging time (T1) elapses from the application of the second vertical sync start signal (STVP).

2. The display device of claim 1, wherein the second output enable signal (OE-C) maintains a logic low level during a logic high period of the first vertical sync start signal (STV).

3. The display device of claim 2, further comprising a signal controller (600) which outputs the first output enable signal (OE), the first vertical sync start signal (STV), and the driving clock signal (CPV).

4. The display device of claim 3,
the gate clock signal (CKV) is a logic high level when the second output enable signal (OE-C) or the driving clock signal (CPV) is a logic low level, the gate clock signal (CKV) is a logic low level when the second output enable signal (OE-C) and the driving clock signal (CPV) are logic low levels,

5. The display device of claim 1, wherein the gate driver (200) is driven in response to the second vertical sync start signal (STVP).

6. The display device of claim 1, wherein the signal converter (700) comprises:
an input/output node (I/O) which receives the first output enable signal (OE) and outputs the second output enable signal (OE-C); and
a switching unit (710) which electrically connects the input/output node (I/O) to ground in response to the first vertical sync start signal (STV).

7. The display device of claim 1, wherein the signal converter (700) comprises:
a first logic gate which performs a NAND operation on the first vertical sync start signal (STV) and the first output enable signal (OE); and
a second logic gate which performs an AND operation on an output of the first logic gate and the first output enable signal (OE).

8. The display device of claim 1, wherein the width of the logic high period of the other gate clock signals (CKV) is approximately 1 H and the width of the logic high period of the first gate clock signal (CKV) is approximately 30-60% of 1H.

9. The display device of claim 1, wherein the gate clock generator (400) inverts the logic levels of the other gate clock signals (CKV) and the gate clock bar signals (CKVB) when a logic OR operation of the second output enable signal (OE-C) and the driving clock signal (CPV) is zero.

10. The display device of claim 1, wherein each of the pixels (PX) comprises:
a thin film transistor (T) connected to the gate line (G); and
a liquid crystal capacitor (Clc) connected to the thin film transistor (T).

11. A method for driving a display device, comprising:
generating an output enable signal (OE) having a logic low level during a logic high period of a first vertical sync start signal (STV) which indicates a start of one frame;
generating gate clock signals (CKV), a gate clock bar signal (CKVB), and a second vertical sync start signal (STVP) using the output enable signal (OE), the first vertical sync start signal (STV), a driving clock signal (CPV), a gate turn-on signal, and a gate turn-off signal in which a width of a logic high period of the gate clock signal (CKV) during the period of the first vertical sync start signal (STV) being smaller than that of gate clock signals (CKV) in the other periods, and the gate clock bar signal (CKVB) has a phase opposite to the other gate clock signals (CKV) after the first gate clock signal (CKV);sequentially applying gate turn-on signals (Von) to a plurality of gate lines (G1 to Gn) according to the second vertical sync start signal (STVP), the gate clock signal (CKV), and the gate clock bar signal (CKVB);
wherein the plurality of gate lines (G1 to Gn) are connected to a plurality of stages (200-1 to 200-n), a first stage (200-1) connected to a first gate line (G1) outputs the gate turn-on signal according to the second vertical sync start signal (STVP) and the first gate clock signal (CKV), and the other stages (200-2 to 200-n) output the gate turn-on signals (Von) according to outputs of previous stages (200-1 to 200-(n-1)), the other gate clock signals (CKV), and the gate clock bar signals (CKVB);
wherein at least the first stage (200-1) includes:
a first transistor (TR1) connected between an input terminal for receiving the gate clock signal (CKV) and a first node (NO1), wherein the first transistor (TR1) provides the gate clock signal (CKV) to a signal output terminal in response to the signal of the first node (NO1),
a second transistor (TR2) connected between an input terminal for receiving the second vertical sync start signal (STVP) and the signal output terminal, wherein the second transistor (TR2) provides the second vertical sync start signal (STVP) to the first node (NO1) in response to the second vertical sync start signal (STVP),
a first capacitor (C1) connected between the first node (NO1) and the signal output terminal, and
wherein the first capacitor (C1) is charged during a charging time (T1) to a voltage (A) corresponding to the voltage level of the second vertical sync start signal (STVP), wherein the gate clock signal (CKV) is applied after the charging time (T1) elapses from the application of the second vertical sync start signal (STVP).

12. The method of claim 11, wherein the width of the logic high period of the gate clock signals (CKV) of the other periods is approximately 1 H, and the width of the logic high period of the gate clock signal (CKV) during the period of the first vertical sync start signal (STV) is approximately 30-60% of 1 H.

13. The method of claim 11, wherein the width of the logic high period of the first vertical sync start signal (STV) is approximately 1 H.

14. The method of claim 11, wherein the logic levels of the other gate clock signals (CKV) and the gate clock bar signals (CKVB) are inverted when a logic OR operation of the output enable signal (OE) and the driving clock signal (CPV) is zero.

15. The display device of claim 1, wherein the first vertical sync start signal (STV) indicates a start of one frame and is a single pulse having one logic high period during the one frame.

16. The display device of claim 9, wherein the first vertical sync start signal (STV) indicates a start of one frame and is a single pulse having one logic high period during the one frame.

## Patentansprüche

1. Anzeigevorrichtung, umfassend:
ein Anzeigefeld (100), umfassend eine Vielzahl von Gate-Leitungen (G1 bis Gn), die mit einer Vielzahl von Pixeln (PX) verbunden sind;
einen Gate-Taktgenerator (400), der Gate-Taktsignale (CKV) erzeugt,
wobei eine Breite einer logischen Hoch-Periode eines ersten Gate-Taktsignals (CKV) während einer Rahmenperiode kleiner als jene anderer Gate-Taktsignale (CKV) ist;
einen Gate-Treiber (200), der gemäß dem Gate-Taktsignal (CKV) und
einem Gate-Taktbalkensignal (CKVB) mit einer Phase, die zu den anderen Gate-Taktsignalen (CKV) entgegengesetzt ist, Gate-Einschaltsignale (Von) nacheinander an die Gate-Leitungen (G1 bis Gn) anlegt, wobei der Gate-Treiber (200) eine Vielzahl von Stufen (200-1 bis 200-n) umfasst, die in das Anzeigefeld (100) integriert sind und jeweils mit der Vielzahl von Gate-Leitungen (G1 bis Gn) verbunden sind, wobei eine erste Stufe (200-1), die mit einer ersten Gate-Leitung (G1) verbunden ist, das Gate-Einschaltsignal gemäß dem zweiten Vertikalsynchronisierungs-Startsignal (STVP) und dem ersten Gate-Taktsignal (CKV) ausgibt und die anderen Stufen (200-2 bis 200-n) die Gate-Einschaltsignale (Von) gemäß den Ausgaben vorheriger Stufen (200-1 bis 200-(n-1)) den anderen Gate-Taktsignalen (CKV) und den Gate-Taktbalkensignalen (CKVB) ausgeben; und
einen Signalwandler (700), der ein zweites Ausgabeaktivierungssignal (OE-C) gemäß einem ersten Ausgabeaktivierungssignal (OE) und einem ersten Vertikalsynchronisierungs-Startsignal (STV) ausgibt, wobei der Gate-Taktgenerator (400) ein zweites Vertikalsynchronisierungs-Startsignal (STVP), das Gate-Taktsignal (CKV) und das Gate-Taktbalkensignal (CKVB) gemäß dem zweiten Ausgabeaktivierungssignal (OE-C), dem ersten Vertikalsynchronisierungs-Startsignal (STV) und einem Ansteuerungs-Taktsignal (CPV) erzeugt,
wobei wenigstens die erste Stufe (200-1) Folgendes umfasst:
einen ersten Transistor (TR1), der zwischen einen Eingangsanschluss zum Empfang des Gate-Taktsignals (CKV) und einen ersten Knoten (NO1) geschaltet ist, wobei der erste Transistor (TR1) dafür geeignet ist, in Reaktion auf das Signal des ersten Knotens (NO1) das Gate-Taktsignal (CKV) an einen Signalausgangsanschluss zu liefern,
einen zweiten Transistor (TR2), der zwischen einen Eingangsanschluss zum Empfang des zweiten Vertikalsynchronisierungs-Startsignals (STVP) und den Signalausgangsanschluss geschaltet ist, wobei der zweite Transistor (TR2) dafür geeignet ist, in Reaktion auf das zweite Vertikalsynchronisierungs-Startsignal (STVP) das zweite Vertikalsynchronisierungs-Startsignal (STVP) an den ersten Knoten (NO1) zu liefern,
einen ersten Kondensator (C1), der zwischen den ersten Knoten (NO1) und den Signalausgangsanschluss geschaltet ist, und
wobei der erste Kondensator (C1) während einer Ladezeit (T1) auf eine Spannung (A) geladen wird, die dem Spannungspegel des zweiten Vertikalsynchronisierungs-Startsignals (STVP) entspricht, wobei das Gate-Taktsignal (CKV) angelegt wird, nachdem die Ladezeit (T1) ab dem Anlegen des zweiten Vertikalsynchronisierungs-Startsignals (STVP) verstreicht.

2. Anzeigevorrichtung nach Anspruch 1, wobei das zweite Ausgabeaktivierungssignal (OE-C) während einer logischen Hoch-Periode des ersten Vertikalsynchronisierungs-Startsignals (STV) einen logisch niedrigen Pegel beibehält.

3. Anzeigevorrichtung nach Anspruch 2, ferner umfassend eine Signalsteuereinrichtung (600), die das erste Ausgabeaktivierungssignal (OE), das erste Vertikalsynchronisierungs-Startsignal (STV) und das Ansteuerungs-Taktsignal (CPV) ausgibt.

4. Anzeigevorrichtung nach Anspruch 3, wobei das Gate-Taktsignal (CKV) einen logisch hohen Pegel aufweist, wenn das zweite Ausgabeaktivierungssignal (OE-C) oder das Ansteuerungs-Taktsignal (CPV) einen logisch niedrigen Pegel aufweist, und wobei das Gate-Taktsignal (CKV) einen logisch niedrigen Pegel aufweist, wenn das zweite Ausgabeaktivierungssignal (OE-C) und das Ansteuerungs-Taktsignal (CPV) logisch niedrige Pegel aufweisen.

5. Anzeigevorrichtung nach Anspruch 1, wobei der Gate-Treiber (200) in Reaktion auf das zweite Vertikalsynchronisierungs-Startsignal (STVP) angesteuert wird.

6. Anzeigevorrichtung nach Anspruch 1, wobei der Signalwandler (700) Folgendes umfasst:
einen Eingabe-/Ausgabe-Knoten (I/O), der das erste Ausgabeaktivierungssignal (OE) empfängt und das zweite Ausgabeaktivierungssignal (OE-C) ausgibt; und
eine Schalteinheit (710), die den Eingabe-/Ausgabe-Knoten (I/O) in Reaktion auf das erste Vertikalsynchronisierungs-Startsignal (STV) elektrisch mit der Erde verbindet.

7. Anzeigevorrichtung nach Anspruch 1, wobei der Signalwandler (700) Folgendes umfasst:
ein erstes Logikgatter, das eine NAND-Operation an dem ersten Vertikalsynchronisierungs-Startsignal (STV) und dem ersten Ausgabeaktivierungssignal (OE) ausführt; und
ein zweites Logikgatter, das eine AND-Operation an einem Ausgang des ersten Logikgatters und dem ersten Ausgabeaktivierungssignal (OE) ausführt.

8. Anzeigevorrichtung nach Anspruch 1, wobei die Breite der logischen Hoch-Periode der anderen Gate-Taktsignale (CKV) annähernd 1 H beträgt und die Breite der logischen Hoch-Periode des ersten Gate-Taktsignals (CKV) annähernd 30 bis 60% von 1 H beträgt.

9. Anzeigevorrichtung nach Anspruch 1, wobei der Gate-Taktgenerator (400) die logischen Pegel der anderen Gate-Taktsignale (CKV) und der Gate-Taktbalkensignale (CKVB) umkehrt, wenn eine logische OR-Operation des zweiten Ausgabeaktivierungssignals (OE-C) und des Ansteuerungs-Taktsignals (CPV) null ist.

10. Anzeigevorrichtung nach Anspruch 1, wobei jedes der Pixel (PX) Folgendes umfasst:
einen Dünnschichttransistor (T), der mit der Gate-Leitung (G) verbunden ist; und
einen Flüssigkristallkondensator (Clc), der mit dem Dünnschichttransistor (T) verbunden ist.

11. Verfahren zum Ansteuern einer Anzeigevorrichtung, umfassend:
Erzeugen eines Ausgabeaktivierungssignals (OE), das während einer logischen Hoch-Periode eines ersten Vertikalsynchronisierungs-Startsignals (STV), das einen Start eines Rahmens anzeigt, einen logisch niedrigen Pegel aufweist,
Erzeugen von Gate-Taktsignalen (CKV), eines Gate-Taktbalkensignals (CKVB) und eines zweiten Vertikalsynchronisierungs-Startsignals (STVP) unter Verwendung des Ausgabeaktivierungssignals (OE), des ersten Vertikalsynchronisierungs-Startsignals (STV), eines Ansteuerungs-Taktsignals (CPV), eines Gate-Einschaltsignals und eines Gate-Ausschaltsignals, wobei eine Breite einer logischen Hoch-Periode des Gate-Taktsignals (CKV) während der Periode des ersten Vertikalsynchronisierungs-Startsignals (STV) kleiner als jene der Gate-Taktsignale (CKV) in den anderen Perioden ist, und wobei das Gate-Taktbalkensignal (CKVB) eine Phase aufweist, die nach dem ersten Gate-Taktsignal (CKV) entgegengesetzt zu jener der anderen Gate-Taktsignale (CKV) ist; nacheinander erfolgendes Anlegen von Gate-Einschaltsignalen (Von) an eine Vielzahl von Gate-Leitungen (G1 bis Gn) gemäß dem zweiten Vertikalsynchronisierungs-Startsignal (STVP), dem Gate-Taktsignal (CKV) und dem Gate-Taktbalkensignal (CKVB);
wobei die Vielzahl von Gate-Leitungen (G1 bis Gn) mit einer Vielzahl von Stufen (200-1 bis 200-n) verbunden sind, wobei eine erste Stufe (200-1), die mit einer ersten Gate-Leitung (G1) verbunden ist, das Gate-Einschaltsignal gemäß dem zweiten Vertikalsynchronisierungs-Startsignal (STVP) und dem ersten Gate-Taktsignal (CKV) ausgibt und die anderen Stufen (200-2 bis 200-n) die Gate-Einschaltsignale (Von) gemäß Ausgaben vorheriger Stufen (200-1 bis 200-(n-1)), den anderen Gate-Taktsignalen (CKV) und den Gate-Taktbalkensignalen (CKVB) ausgeben;
wobei wenigstens die erste Stufe (200-1) Folgendes umfasst:
einen ersten Transistor (TR1), der zwischen einen Eingangsanschluss zum Empfang des Gate-Taktsignals (CKV) und einen ersten Knoten (NO1) geschaltet ist, wobei der erste Transistor (TR1) in Reaktion auf das Signal des ersten Knotens (NO1) das Gate-Taktsignal (CKV) an einen Signalausgangsanschluss liefert,
einen zweiten Transistor (TR2), der zwischen einen Eingangsanschluss zum Empfang des zweiten Vertikalsynchronisierungs-Startsignals (STVP) und den Signalausgangsanschluss geschaltet ist, wobei der zweite Transistor (TR2) in Reaktion auf das zweite Vertikalsynchronisierungs-Startsignal (STVP) das zweite Vertikalsynchronisierungs-Startsignal (STVP) an den ersten Knoten (NO1) liefert,
einen ersten Kondensator (C1), der zwischen den ersten Knoten (NO1) und den Signalausgangsanschluss geschaltet ist, und
wobei der erste Kondensator (C1) während einer Ladezeit (T1) auf eine Spannung (A) geladen wird, die dem Spannungspegel des zweiten Vertikalsynchronisierungs-Startsignals (STVP) entspricht, wobei das Gate-Taktsignal (CKV) angelegt wird, nachdem die Ladezeit (T1) ab dem Anlegen des zweiten Vertikalsynchronisierungs-Startsignals (STVP) verstreicht.

12. Verfahren nach Anspruch 11, wobei die Breite der logischen Hoch-Periode der Gate-Taktsignale (CKV) der anderen Perioden annähernd 1 H beträgt und die Breite der logischen Hoch-Periode des Gate-Taktsignals (CKV) während der Periode des ersten Vertikalsynchronisierungs-Startsignals (STV) annähernd 30 bis 60% von 1 H beträgt.

13. Verfahren nach Anspruch 11, wobei die Breite der logischen Hoch-Periode des ersten Vertikalsynchronisierungs-Startsignals (STV) annähernd 1 H beträgt.

14. Verfahren nach Anspruch 11, wobei die Logikpegel der anderen Gate-Taktsignale (CKV) und der Gate-Taktbalkensignale (CKVB) umgekehrt werden, eine logische OR-Operation des Ausgabeaktivierungssignals (OE) und des Ansteuerungs-Taktsignals (CPV) null ist.

15. Anzeigevorrichtung nach Anspruch 1, wobei das erste Vertikalsynchronisierungs-Startsignal (STV) einen Start eines Rahmens anzeigt und ein einzelner Impuls ist, der während des einen Rahmens eine logische Hoch-Periode aufweist.

16. Anzeigevorrichtung nach Anspruch 9, wobei das erste Vertikalsynchronisierungs-Startsignal (STV) einen Start eines Rahmens anzeigt und ein einzelner Impuls ist, der während des einen Rahmens eine logische Hoch-Periode aufweist.

## Revendications

1. Dispositif d'affichage comprenant :
un panneau d'affichage (100) comprenant un grand nombre de lignes de grille (G1 à Gn) connectées à un grand nombre de pixels (PX) ;
un générateur d'horloge de grille (400) qui génère des signaux d'horloge de grille (CKV) dans lesquels une largeur d'une période d'état logique haut d'un premier signal d'horloge de grille (CKV) est plus petite que celle d'autres signaux d'horloge de grille (CKV) pendant une période de trame ;
un excitateur de grille (200) qui applique successivement des signaux d'activation de grille (Von) aux lignes de grille (G1 à Gn) selon le signal d'horloge de grille (CKV) et un signal de barrage d'horloge de grille (CKVB) dont la phase est opposée à celle des autres signaux d'horloge de grille (CKV), l'excitateur de grille (200) comprenant un grand nombre d'étages (200-1 à 200-n) intégrés dans le panneau d'affichage (100) et connectés respectivement au grand nombre de lignes de grille (G1 à Gn), un premier étage (200-1) connecté à une première ligne de grille (G1) émettant le signal d'activation de grille en sortie selon le deuxième signal de début de synchronisation verticale (STVP) et le premier signal d'horloge de grille (CKV), et les autres étages (200-2 à 200-n) émettant les signaux d'activation de grille (Von) en sortie selon les sorties des étages précédents (200-1 à 200-(n-1)), les autres signaux d'horloge de grille (CKV) et les signaux de barrage d'horloge de grille (CKVB) ; et
un convertisseur de signaux (700) qui émet en sortie un deuxième signal d'activation de sortie (OE-C) selon un premier signal d'activation de sortie (OE) et un premier signal de début de synchronisation verticale (STV), le générateur d'horloge de grille (400) générant un deuxième signal de début de synchronisation verticale (STVP), le signal d'horloge de grille (CKV) et le signal de barrage d'horloge de grille (CKVB) selon le deuxième signal d'activation de sortie (OE-C), le premier signal de début de synchronisation verticale (STV) et un signal d'horloge d'excitation (CPV),
dans lequel le premier étage (200-1) au moins comprend :
un premier transistor (TR1) connecté entre une borne d'entrée pour la réception du signal d'horloge de grille (CKV) et un premier noeud (NO1), le premier transistor (TR1) étant adapté pour fournir le signal d'horloge de grille (CKV) à une borne de sortie de signal en réponse au signal du premier noeud (NO1),
un deuxième transistor (TR2) connecté entre une borne d'entrée pour la réception du deuxième signal de début de synchronisation verticale (STVP) et la borne de sortie de signal, le deuxième transistor (TR2) étant adapté pour fournir le deuxième signal de début de synchronisation verticale (STVP) au premier noeud (NO1) en réponse au deuxième signal de début de synchronisation verticale (STVP),
une première capacité (C1) montée entre le premier noeud (NO1) et la borne de sortie de signal, et
dans lequel la première capacité (C1) est chargée pendant un temps de charge (T1) à une tension (A) correspondant au niveau de tension du deuxième signal de début de synchronisation verticale (STVP), le signal d'horloge de grille (CKV) étant appliqué après l'écoulement du temps de charge (T1) à partir de l'application du deuxième signal de début de synchronisation verticale (STVP).

2. Dispositif d'affichage selon la revendication 1, dans lequel le deuxième signal d'activation de sortie (OE-C) maintient un niveau logique bas pendant une période d'état logique haut du premier signal de début de synchronisation verticale (STV).

3. Dispositif d'affichage selon la revendication 2, comprenant en outre un contrôleur de signaux (600) qui émet en sortie le premier signal d'activation de sortie (OE), le premier signal de début de synchronisation verticale (STV) et le signal d'horloge d'excitation (CPV).

4. Dispositif d'affichage selon la revendication 3, dans lequel le signal d'horloge de grille (CKV) est au niveau logique haut quand le deuxième signal d'activation de sortie (OE-C) ou le signal d'horloge d'excitation (CPV) est au niveau logique bas, et le signal d'horloge de grille (CKV) est au niveau logique bas quand le deuxième signal d'activation de sortie (OE-C) et le signal d'horloge d'excitation (CPV) sont au niveau logique bas.

5. Dispositif d'affichage selon la revendication 1, dans lequel l'excitateur de grille (200) est excité en réponse au deuxième signal de début de synchronisation verticale (STVP).

6. Dispositif d'affichage selon la revendication 1, dans lequel le convertisseur de signaux (700) comprend :
un noeud d'entrée/sortie (I/O) qui reçoit le premier signal d'activation de sortie (OE) et émet en sortie le deuxième signal d'activation de sortie (OE-C) et
une unité de commutation (710) qui connecte électriquement le noeud d'entrée/sortie (I/O) à la masse en réponse au premier signal de début de synchronisation verticale (STV).

7. Dispositif d'affichage selon la revendication 1, dans lequel le convertisseur de signaux (700) comprend :
une première porte logique qui exécute une opération N-ET sur le premier signal de début de synchronisation verticale (STV) et le premier signal d'activation de sortie (OE) ; et
un deuxième opérateur logique qui exécute une opération ET sur une sortie de la première porte logique et le premier signal d'activation de sortie (OE).

8. Dispositif d'affichage selon la revendication 1, dans lequel la largeur de la période d'état logique haut des autres signaux d'horloge de grille (CKV) est d'environ 1 H et la largeur de la période d'état logique haut du premier signal d'horloge de grille (CKV) est d'environ 30 % à 60 % de 1 H.

9. Dispositif d'affichage selon la revendication 1, dans lequel le générateur d'horloge de grille (400) inverse les niveaux logiques des autres signaux d'horloge de grille (CKV) et des signaux de barrage d'horloge de grille (CKVB) quand une opération logique OU du deuxième signal d'activation de sortie (OE-C) et du signal d'horloge d'excitation (CPV) donne zéro.

10. Dispositif d'affichage selon la revendication 1, dans lequel chacun des pixels (PX) comprend :
un transformateur à couches minces (T) connecté à la ligne de grille (G) et
une capacité à cristaux liquides (Clc) connectée au transformateur à couches minces (T).

11. Procédé pour piloter un dispositif d'affichage, comprenant :
la génération d'un signal d'activation de sortie (OE) qui est à un niveau logique bas pendant une période d'état logique haut d'un premier signal de début de synchronisation verticale (STV) indiquant le début d'une trame ;
la génération de signaux d'horloge de grille (CKV), d'un signal de barrage d'horloge de grille (CKVB) et d'un deuxième signal de début de synchronisation verticale (STVP) à l'aide du signal d'activation de sortie (OE), du premier signal de début de synchronisation verticale (STV), d'un signal d'horloge d'excitation (CPV), d'un signal d'activation de grille et d'un signal de désactivation de grille dans laquelle une largeur d'une période d'état logique haut du signal d'horloge de grille (CKV) pendant la période du premier signal de début de synchronisation verticale (STV) est plus petite que celle des signaux d'horloge de grille (CKV) des autres périodes, et le signal de barrage d'horloge de grille (CKVB) a une phase opposée à celle des autres signaux d'horloge de grille (CKV) après le premier signal d'horloge de grille (CKV) ;
l'application successive de signaux d'activation de grille (Von) à un grand nombre de lignes de grille (G1 à Gn) selon le deuxième signal de début de synchronisation verticale (STVP), le signal d'horloge de grille (CKV) et le signal de barrage d'horloge de grille (CKVB) ;
dans lequel le grand nombre de lignes de grille (G1 à Gn) est connecté à un grand nombre d'étages (200-1 à 200-n), un premier étage (200-1) connecté à une première ligne de grille (G1) émettant le signal d'activation de grille en sortie selon le deuxième signal de début de synchronisation verticale (STVP) et le premier signal d'horloge de grille (CKV), et les autres étages (200-2 à 200-n) émettant en sortie les signaux d'activation de grille (Von) selon les sorties des étages (200-1 à 200-(n-1)) précédents, les autres signaux d'horloge de grille (CKV) et les signaux de barrage d'horloge de grille (CKVB);
le premier étage (200-1), au minimum, comprenant :
un premier transistor (TR1) connecté entre une borne d'entrée pour la réception du signal d'horloge de grille (CKV) et un premier noeud (NO1) lequel premier transistor (TR1) fournit le signal d'horloge de grille (CKV) à une borne de sortie de signal en réponse au signal du premier noeud (NO1),
un deuxième transistor (TR2) connecté entre une borne d'entrée pour la réception du deuxième signal de début de synchronisation verticale (STVP) et la borne de sortie de signal, lequel deuxième transistor (TR2) fournit le deuxième signal de début de synchronisation verticale (STVP) au premier noeud (NO1) en réponse au deuxième signal de début de synchronisation verticale (STVP),
une première capacité (C1) montée entre le premier noeud (NO1) et la borne de sortie de signal, et
la première capacité (C1) étant chargée pendant un temps de charge (T1) à une tension (A) qui correspond au niveau de tension du deuxième signal de début de synchronisation verticale (STVP), le signal d'horloge de grille (CKV) étant appliqué après l'écoulement du temps de charge (T1) depuis l'application du deuxième signal de début de synchronisation verticale (STVP).

12. Procédé selon la revendication 11, dans lequel la largeur de la période d'état logique haut des signaux d'horloge de grille (CKV) des autres périodes est d'environ 1 H et la largeur de la période d'état logique haut du signal d'horloge de grille (CKV) pendant la période du premier signal de début de synchronisation verticale (STV) est d'environ 30 % à 60 % de 1 H.

13. Procédé selon la revendication 11, dans lequel la largeur de la période d'état logique haut du premier signal de début de synchronisation verticale (STV) est d'environ 1 H.

14. Procédé selon la revendication 11, dans lequel les niveaux logiques des autres signaux d'horloge de grille (CKV) et les signaux de barrage d'horloge de grille (CKVB) sont inversés quand une opération logique OU sur le signal d'activation de sortie (OE) et le signal d'horloge d'excitation (CPV) donne zéro.

15. Dispositif d'affichage selon la revendication 1, dans lequel le premier signal de début de synchronisation verticale (STV) indique le début d'une trame et il s'agit d'une impulsion unique ayant une période d'état logique haut pendant la trame en question.

16. Dispositif d'affichage selon la revendication 9, dans lequel le premier signal de début de synchronisation verticale (STV) indique le début d'une trame et il s'agit d'une impulsion unique ayant une période d'état logique haut pendant la trame en question.
